Europäisches Patentamt

European Patent Office

Office européen des brevets

(19)

(11) Publication number: **0 079 931**
**B1**

# EUROPEAN PATENT SPECIFICATION

(12)

(45) Date of publication of patent specification: **11.03.87**

(21) Application number: **82901884.5**

(22) Date of filing: **03.05.82**

(86) International application number:
**PCT/US82/00587**

(87) International publication number:
**WO 82/04351 09.12.82 Gazette 82/29**

(51) Int. Cl.⁴: **H 01 J 37/30, H 01 J 37/317**

(54) FOCUSED ION BEAM MICROFABRICATION COLUMN.

(30) Priority: **26.05.81 US 267237**

(43) Date of publication of application:
**01.06.83 Bulletin 83/22**

(45) Publication of the grant of the patent:
**11.03.87 Bulletin 87/11**

(84) Designated Contracting States:
**BE CH DE FR GB LI NL SE**

(56) References cited:
**FR-A-2 183 853**
**US-A-3 547 074**
**US-A-3 585 397**
**US-A-3 786 359**
**US-A-4 085 330**
**US-A-4 315 153**

**JAPANESE JOURNAL OF APPLIED PHYSICS.
SUPPL., vol. 21, no. 1, 1982 TOKYO (JP) R.L.
SELIGER et al.: "Fine Focused Ion Beams",
pages 3-10.**

**EXTENDED ABSTRACTS. THE
ELECTROCHEMICAL SOCIETY, INC. SPRING
MEETING, Washington, D.C., vol. 76-1, May
2-7, 1976 PRINCETON (US) J.H. JACKSON et
al.: "PR-500, a high voltage, general purpose
ion implantation system", abstract no. 207,
pages 523-525.**

(73) Proprietor: **Hughes Aircraft Company
7200 Hughes Terrace P.O. Box 45066
Los Angeles California 90045-0066 (US)**

(72) Inventor: **WARD, William J.
7236 Cirrus Way
Canoga Park, CA 91304 (US)**
Inventor: **WANG, Victor
1648 Lookout Drive
Agoura, CA 91301 (US)**
Inventor: **VAHRENKAMP, Richard P.
3918 Mayfield Street
Newberry Park, CA 91320 (US)**
Inventor: **SELIGER, Robert L.
29393 Hillrise Drive
Agoura, CA 91301 (US)**

(74) Representative: **Crawford, Andrew Birkby et al
A.A. THORNTON & CO. Northumberland House
303-306 High Holborn
London WC1V 7LE (GB)**

(56) • References cited:
**JAPANESE JOURNAL OF APPLIED PHYSICS,
vol. 16, no. 2, February, 1977 K. YAGI et al.:
"Germanium and Silicon Film Growth by
Low-Energy Ion Beam Deposition", pages 245-
251.**

EP 0 079 931 B1

**0 079 931**

(56) References cited:

**Applied Physics Letters, issued 01 November 1975, V.E. KROHN and G.R. RINGO, Ion Source of High Brightness Using Liquid Metal, see page 479.**

**Mass Spectroscopy, issued September 1974, TOSHIO KONDO et al, Ion Microprobe Analyzer with Wien Filter for Primary Ion Mass Separation, see page 229.**

## Description

The United States Government has rights in this invention pursuant to Contract No. 116870.

### Background of the invention

This invention is directed to a device for producing a mass separated ion beam which is finely focused and which has selectable energy. This direct-write ion beam may be used for directly writing on a semiconductor target to produce a semiconductor device without the use of masks.

Conventional ion implantation has emerged from research into manufacturing. In the conventional ion implantation, a broad approximately 1 cm in diameter ion beam is raster scanned over a wafer to create a uniformly implanted layer. Pattern definition is achieved through conventional masking (as by lithography) which involves a thin film of silicon dioxide or sometimes metal over the substrate.

Using focused ion beams is an elegant technique for microfabrication in that it eliminates conventional masking and wet process steps. The basic idea behind the focused ion beam is the elimination of all masking steps. The beam should therefore be focused sufficiently so that implantation patterns can be written by programming the beam deflection and blanking the beam. Prior effort at providing a finely focused ion beam with sufficient energy for implantation was not successful. Prior effort by R. L. Seliger and W. P. Fleming, as published March 1974 in the Journal of Applied Physics, Volume 45 Number 3, produced microprobes with about 5 micrometer spot diameter and with a maximum beam energy of about 60 kV. Such beams had current which was too low for most applications.

The convention ion implantation comprising scanning with a broad ion beam and achieving pattern definition through conventional masking, as described above, may employ an ion beam device as described in J. H. Jackson et al, "PR-500 A High Voltage, General Purpose Ion Implantation System", Extended Abstracts, The Electrochemical Society, Inc., Spring Meeting, Washington D.C., Vol. 76-1, Abstract No. 207, pages 523—25, May 2—7, 1976. The ion beam device disclosed therein comprises a column enclosure around an ion beam part for maintaining a vacuum along the ion beam path, an ion source at one end of the ion beam path for providing ions of a selected species, means for extracting an angularly expanding ion beam from the source with an initial energy which is low compared to the final beam energy, a target support positioned at the other end of the ion beam path for positioning a target on the ion beam path for receiving ions, a first lens positioned along the ion beam path between the ion source and the target support and an ion analyzer positioned downstream of the first lens for directing the selected ion species along the beam path and for directing undesired ion species away from the beam path. In this arrangement a Penning ion source is used to produce target current in the range 400—600 μA. After extraction, the ion beam is focused by an einzel lens for entry into a mass separator or ion analyzer. The beam is then focused to a desired collimation by a second einzel lens, after which is brought to a final energy of up to 500 KeV by a constant gradient accelerator. Although not specifically stated, the Jackson et al system appears to generate a large diameter beam probably in the range of 2 to 5 centimetres which is used to flood an entire wafer with ions.

However, the Jackson et al device is not concerned with a direct-write system which produces a focus spot in the order of 0.1—0.2 microns wherein very small currents are employed. When it is desired to produce very small currents of small diameter it is necessary to produce a beam spot with a system which minimizes beam aberrations. In the Jackson et al system the relatively large distance between the mass analyzer slits and the second lens and the fact that both einzel lenses are non accelerating provides a system which would introduce great aberrations for small diameter spots. In addition the Jackson et al system provides a fixed final energy whereas for direct write systems it is frequently necessary to produce a variable energy in order to vary the depth of penetration of the ions into the target.

U.S. Patent US—A—3 585 397 to Brewer discloses a method of forming a focused ion beam having a small spot size at a target for direct-write microfabrication, comprising forming an angularly expanding beam of a desired ion species, focusing the beam to a crossover and mass separating the beam with relatively weak fields to deflect undesired ion species out of the beam path. The beam is then focused and deflected to a desired position on a target. However the ion source forming the beam was not a high brightness, small diameter ion source, and ions were flooded onto a small aperture and imaged the aperture at the target. In that structure the ion current was too low to be useful for practical implantation and the problems of accelerating the ion beam while maintaining high resolution had not been understood. Thus it was not capable of satisfactory direct writing with an ion implantation beam having a sufficient current and sufficiently small diameter at the target for use in modern day semiconductor development and manufacture.

It is an object of the present invention to provide a high resolution focused ion beam having a small spot size and a high current density for satisfactory direct-write microfabrication.

Accordingly, the present invention provides a method of forming a high resolution, focused ion beam having a small spot size and a high current density at a target for direct-write microfabrication, comprising the steps of:

forming an angularly expanding beam of a desired ion species at an initial energy level, focusing the beam to a crossover,

mass separating the beam downstream of said focusing to deflect undesired ion species out of the beam path,

accelerating the mass separated beam in the vicinity of the beam crossover to an intermediate energy level,

electrostatically focusing and accelerating the beam beyond the crossover to a small spot with a high current density at a final energy level,

setting the intermediate beam energy level and final beam energy level so that the intermediate energy beam level is a substantially constant fraction of the final beam energy level, and

deflecting the spot over a target to implant a desired ion pattern on the target.

In a further aspect the invention comprises an ion beam device for carrying out the aforesaid method, the device comprising:

a column enclosure around an ion beam path for maintaining a vacuum along the ion beam path;

an ion source at one end of the ion beam path for providing ions of a selected species;

means for extracting an angularly expanding ion beam from the source;

a target support positioned at the other end of the ion beam path for positioning a target on the ion beam path for receiving ions;

a first lens positioned along the ion beam path between said ion source and said target support, said first lens being an objective lens focusing an image of said ion source at a first focal plane;

mass separating means comprising an ion analyzer positioned downstream of said first lens for directing the selected ion species along the beam path and for directing undesired ion species away from the beam path, and an analyzer plate lying substantially at said first focal plane and having an opening therethrough, said opening lying on the beam path so that undesired ion species strike said analyzer plate away from said opening;

energy control means positioned in the beam path beyond the ion analyzer for accelerating the ion beam to an intermediate energy level;

an electrostatic accelerator lens being a final accelerator lens for accelerating the ion beam as well as focusing and demagnifying the image of the ion beam at said first focal plane on to a target on said target support so that a demagnified image of said ion source is focused on the target;

a variable power supply connected to apply respective voltage differentials across the energy control means and accelerator lens sufficient to focus the beam to a small spot with a high current density and to establish the intermediate energy level of the beam emerging from the energy control means at a substantially constant fraction of the beam energy emerging from the accelerator lens as the power supply is varied; and

means for deflecting the focus beam relative to the target in a desired manner.

Thus the present invention is directed to a focused ion beam microfabrication device wherein an ion source produces ions from a sufficiently small spot and with sufficiently high intensity that the beam can be separated, focused, accelerated, and deflected on to a target. By such a structure, a computer can control the beam for implantation, mask exposure, ion beam machining and similar integrated circuits semiconductor processes to produce a unique integrated circuit in accordance with the programming of the controlling computer. The device produces a focused and separated ion beam for unique integrated circuit fabrication in accordance with computer control. The device has a high ion current density in a sufficiently small spot size for direct implantation. It provides a beam of selectable energy and of selectable ion species and provide purer ion species in the beam. These advantages accrue from the use of a liquid metal ion source, electrostatic lenses and deflectors and an ExB mass separator in the column. The device is useful in the field of semiconductor and integrated circuit fabrication particularly by providing a small dimension high resolution small scanning ion spot. It is a further advantage of this device to provide flexibility in implantation because all pattern information is stored in the software which controls the scanning spot to provide a simple and elegant implantation process with fewer steps because no masks are required. It is another advantage to provide such a device wherein integrated circuit devices can be produced by an all dry (no masking and etching) method. It is a further advantage to provide such a device which is useful as a small spot, high current microprobe and is also useful for resist exposure in conventional wet processing integrated circuit work.

Other purposes and advantages of this invention will become apparent from a study of the following portion of this specification, the claims and the attached drawings.

Brief description of the drawings

Fig. 1 is a perspective view of the focused ion beam microfabrication column of this invention, taken in section to the axial center line, with one quadrant removed.

Fig. 2 is a similar view of a subassembly thereof which carries focussing elements and mass separation.

Fig. 3 is a schematic diagram of the functional portions of the column, with the elements thereof taken in section and broken away to the axis of the beam.

Fig. 4 is a simplified schematic of the column of this invention, showing the principal potentials applied thereto.

Description of the preferred embodiment

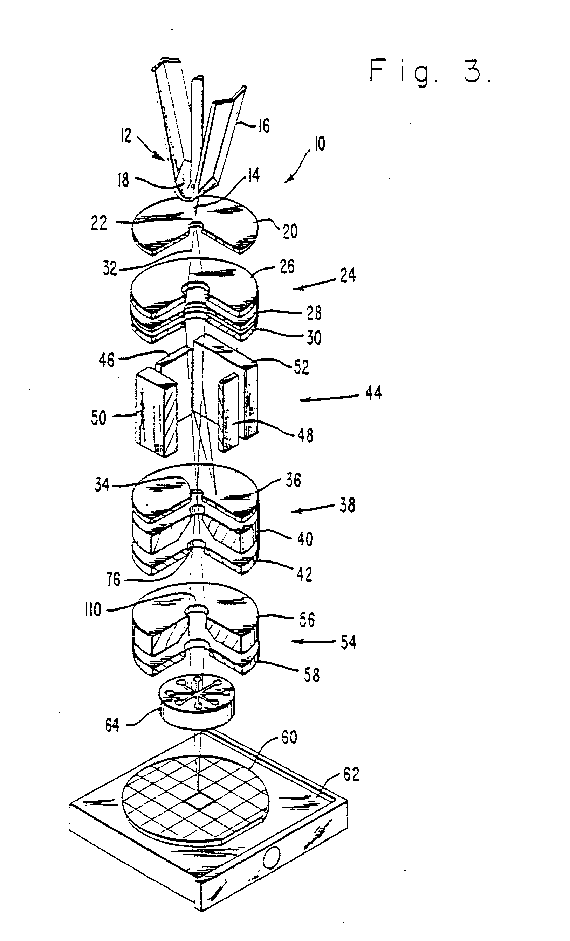

The schematic drawing of Fig. 3 illustrates the inter-relationship of the various elements of the focused ion beam microfabrication column 10 of this invention.

Ion source 12 is a high brightness ion source which produces a beam of charged particles that appear to emanate from a very small point. Ion source 12 has a sharp point 14 which extends through the apex of hairpin shaped heater 16. Metal 18 is placed within the hairpin and is melted by the heater. The metal 18 is the feed metal which supplies the ions. The feed metal may be an element or alloy containing the desired species. By capillarity, the metal moves to the point 14 where it is ionized in the electric field. This high brightness ion source produces a beam of charged particles that appear to emanate from a very small point. Gallium is often used as an ion source to produce gallium ions for use in a column of this type.

Extraction electrode 20 has a central beam opening 22 on the axis of the beam, as seen in Fig. 3.

The optical design of the column 10 separates its function into physically separate regions. The results of the structure which are new and unique to this design are mass separation, variable beam energy and high final beam energy in a single compact column structure. Mass separation requires a transverse magnetic field which is a potential source of focusing aberration. To minimize this aberration, the magnetic field strength in the separator is minimized. To accomplish mass separation with minimum magnetic field, it is performed at the lowest beam energy, at beam extraction potential. The best use of the separator strength is obtained by positioning the separator slit at the beam focus or cross-over where the greatest resolution between ion species is available.

Objective lens 24 is in the form of an einzel lens having electrodes 26, 28 and 30. These three electrodes each also have a beam opening through the center thereof on the beam axis. The objective lens 24 was chosen to be an einzel lens so that the beam energy was not increased before the mass separator. Objective lens 24 is intended to operate in the accelerating mode, in which the ions are accelerated between electrodes 26 and 28 and are decelerated to the input energy level between electrodes 28 and 30. Operating objective lens 24 in the accelerating mode has lower aberration than if it would be operated in the decelerating case, but the accelerating mode requires a greater electric field strength. Ion source 12 is placed as close as possible to lens 24 to minimize aberration. Ion beam 32 has been extracted by electrode 20 and is magnified and focused by objective lens 24. It is focused with a beam crossover at the analyzer opening 34 in aperture plate 36 above pre-accelerator lens 38. Magnification of the spot at plate 36 provides a longer space between lens 24 and aperture plate 36 so that there is room for filter 44. Pre-accelerator lens 38 has first and second electrodes 40 and 42, also with openings on the beam axis.

ExB mass separator 44 is positioned along the beam path between objective lens 24 and pre-accelerator lens 38. As described, the beam is at low, extraction energy at this position and thus an ExB filter of minimum strength of magnetic and electric fields is possible. In this structure, the desired species is passed by the separator with minimum aberration in a straight line. In addition the small diameter at the beam substantially reduces the aberration, as compared to a larger beam. Beam opening 34 in the aperture plate 38 serves as the separation slit. As previously indicated, beam opening 34 is located at the first beam crossover which is the narrow beam waist at focus, and thus a minimum size aperture at that point is possible. In mass separator 44, electric field plates 46 and 48 are positioned parallel to each other, parallel to the center line axis of the column, which is in the beam path, and facing each other as indicated. Magnetic pole pieces 50 and 52 are connected by a magnetic field producing device. A permanent magnet is preferred, but an electric coil producing a magnetic field can be employed. The pole pieces are of the same length and the direction of the beam as the electric field plates 46, 48. The combined results are such that an ion of the selected species passes straight through, and passes through beam opening 34 while an ion of another species is deflected. Variation of the electric and magnetic fields across the diameter of the beam can introduce aberrations in the beam. In order to limit these aberrations, the beam must be narrow and the magnetic pole pieces and electric field plates may be flat and parallel or specially shaped to control the fields. Also, the width of these elements should be much larger than the beam diameter so that lateral fringe-field effects are small. Furthermore, the entrance and exit to the field zone must be carefully controlled because of fringe-fields at the ends.

Pre-accelerator lens 38 comprised of elements 40 and 42 is used to vary the beam energy entering the final accelerating lens 54. The image of the source 12 is focused by einzel lens 24 and is positioned near the principal plane of pre-accelerator lens 38. The principal plane and focus are about at the level of separator plate 36. With this focus or beam cross-over, the beam appears to emanate from pre-accelerator lens 38 with no focusing affect and only a change in energy. By simultaneously adjusting the final lens voltage together with the pre-accelerator lens voltage so that the lens voltage ratio is nearly constant, the beam will remain in focus at the target as the final beam energy is varied. A conventional acceleration gap not located at beam crossover will introduce a focus effect which would change with voltage. This would change the operating conditions of the following lenses, typically requiring change in position of the final focal plane.

Final accelerator lens 54 has electrodes 56 and 58 which apply the accelerating voltage to the ion beam. The lens also focuses and demagnifies the diverging beam from the pre-accelerator lens 38 onto the target. The demagnifying by this lens produces the small beam spot on the target. In the present case the target is semiconductor wafer 60 which is mounted on stage 62. The stage can be moved so that different areas of the semiconductor wafers can be acted upon by the beam.

Translation of the beam is produced by beam deflector 64 which is positioned around the beam between the final accelerator lens 54 and target 60. The beam deflector is electrostatic, and may have four poles. In the present case, eight poles are employed. Beam deflection and acceleration are controlled by a suitable program, such as a computer program, so that the desired pattern is traced on the target by the beam. It is thus seen that the basic concept is a three lens design for selectable acceleration and fixed focus of the ion beam. The position of the pre-accelerator lens 38 at the focal point of objective lens 24, and the mass separator 44 between the extraction electrode 20 and mass separator 44 is the basic structural concept.

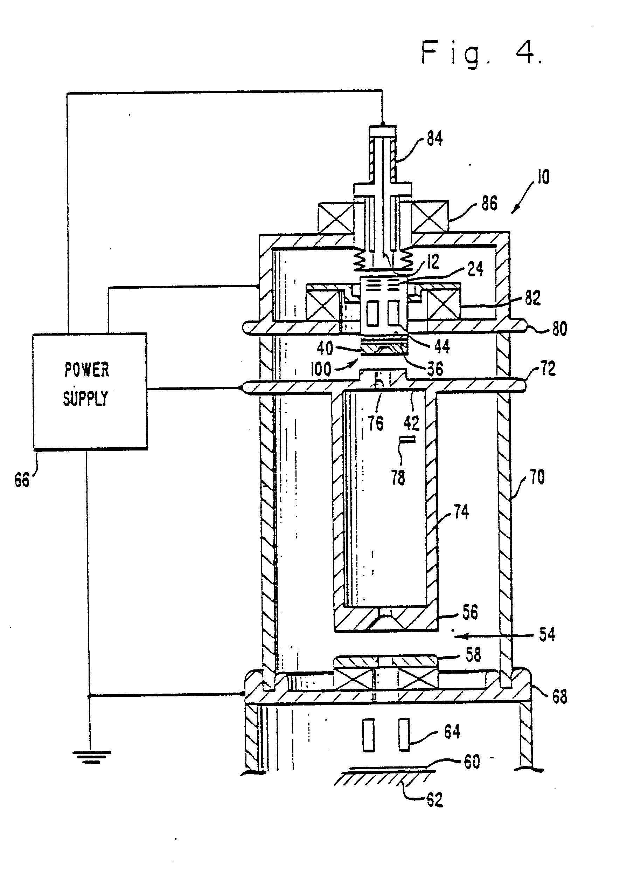

The potentials are illustrated with respect to the schematic diagram of column 10 shown in Fig. 4. Starting at the lower end of the column, and at the lower potential, target 60, on stage 62, and the octupole beam deflector 64 are at ground potential. The electronics driving the deflection circuits and the stage positioning are thus at a convenient potential. Power supply 66 is connected to base plate 68 to provide this potential. Of course, small excursions from that potential are experienced by the beam deflector 64. The motors in stage 62 are also suitably powered around the ground potential. Base plate 68 supports insulator tube 70 and isolates the final accelerator-lens potential of the upper flange 72 from the ground. As is seen in Fig. 4, upper flange 72 supports the upper half 56 of the final accelerator lens 54 on drift tube 74. As is seen in the simplified schematic of Fig. 4, upper flange 72 has an opening 76 therein at the potential of upper flange 72 so that the ion beam passing through opening 76 to electrode 56 of the final accelerator lens 54 drifts down through the tube, without acceleration or deflection therein. The purpose of the drift tube is to space the final accelerator lens 58 from the beam focal point at the top of electrode 36 of pre-accelerator lens 38. As is seen in Fig. 3, this spacing is needed for focal purposes.

Surrogate target 78 is movable into the beam path as an intermediate target. By reducing the focusing voltage (and thus increasing the focal length) of the first einzel lens 24, the beam can be brought to a focus at target 78 so that the upper portion of the column can be evaluated separately from the high voltage final accelerator lens. Upper flange 72 is connected to the power supply 66 to provide the accelerating voltage, 125 kv in this preferred embodiment. Lower electrode 42 of the pre-accelerator lens 38 is at a potential of upper flange 72.

Top flange 80 provides a bulkhead which is at 144 kV at the highest potential in the present example. This is the potential of the aperture plate 36 and the upper electrode 40 in pre-accelarator lens 38. Aperture plate 36 is supported on top flange 80 in alignment along the beam path. Support ring 82 supports module 100 which contains aperture plate 36, electrode 40 and ExB separator 44 on top flange 80. The ExB separator 44 is at the potential of the top flange 80. Power supply 66 has a second winding in its high voltage isolation transformer to provide the deflection supplies for the electric field plates 46 and 48. The center element 28 of einzel lens 24 is supplied by a separate negative 30 kV high voltage power supply through a suitable high voltage feedthrough insulator bushing through the top flange.

Power supply 66 is also connected to ion source 12. In the preferred embodiment, the ion source 12 is operated at 6 kV with respect to the top flange 80 for a total maximum of 150 kV with respect to the target. The ion source 12 is insulated from its housing by insulator tube 84 so that it can be supported on support ring 86 with respect to the top flange.

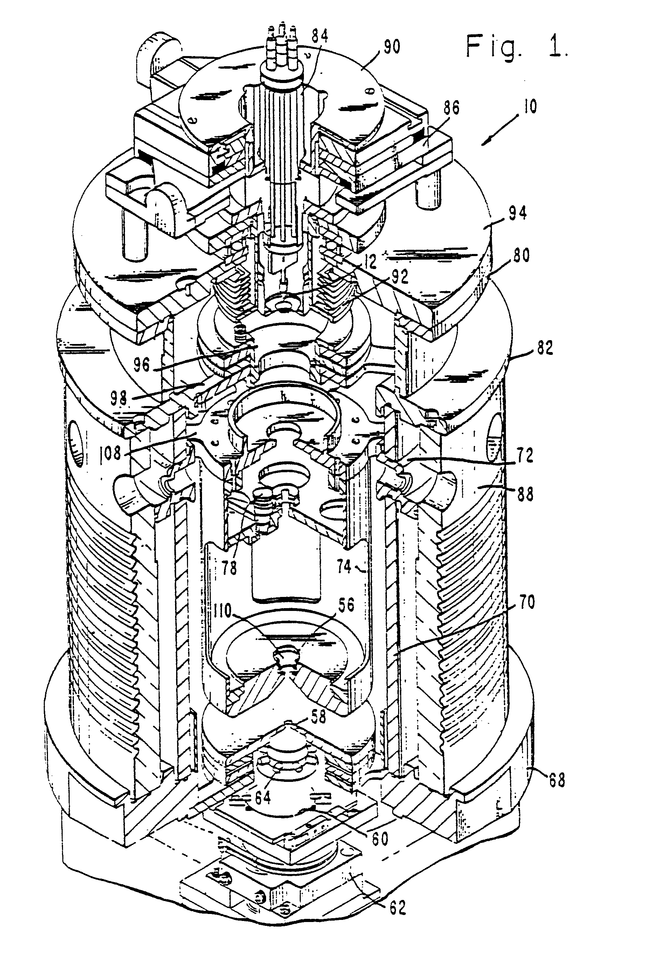

The column is shown in overall structural detail in Fig. 1. Insulator tube 70, which withstands the major potential difference between base plate 68 and upper flange 72 is a ceramic cylinder which serves as a vacuum wall so that vacuum can be maintained therein along the beam path. Insulator tube 70 is a cylinder with a sufficiently high insulation value that it can stand off the voltage on the vacuum side therein without gradient rings. However, it may not have sufficient mechanical strength and does not have sufficient length to hold off the voltage on the exterior thereof in air. Therefore, tension tube 88 in the form of a cylindrical tube is positioned therein. Tension tube 88 is a glass fiber-epoxy structure which serves as a structural member to seat the O-rings on the ends of tube 70. In addition it is a pressure vessel around insulator tube 70 to provide an annular space therebetween. The annular space is filled with an insulator gas such as Freon 113 or $SF_6$. This provides sufficient breakdown strength along the length of alumina insulator tube 70 on the exterior thereof. Breakdown across the exterior of tension tube 88, which is in air, is prevented by the superior surface breakdown properties of glass fiber-epoxy and by the ribbed convolutions formed on the exterior thereof to increase the surface breakdown path length. An O-ring seals the insulator gas in the annular space. Electrical access to the lower flange electrical connections is provided by windows through the two tubes which are provided with suitable feedthrough bushings and seals. At the top of the column as seen in Fig. 1, inverted hat-shaped transition piece 90 supports the liquid metal ion source on support ring 86. The support ring is a device which can suitably adjust the ion source 12 with respect to the central axis or beam path of the column 10. Bellows 92 permits lateral motion of ion source 12 and seals the source structure with respect to the main interior volume of the column so that the interior can be evacuated as required. Flange 94 mounts the ion source on top flange 80 at the top of the column.

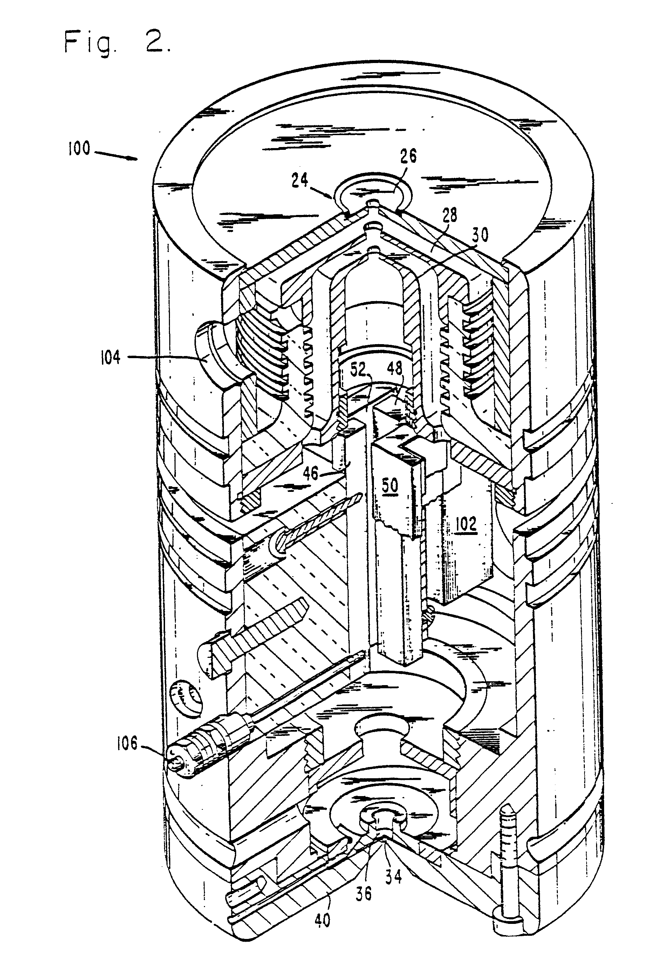

Module 100, see Fig. 2, is mounted in ring 96, which is carried on a spider 98 mounted on top flange 80. As is seen in Fig. 2, module 100 contains the electrodes 26, 28 and 30 of the objective einzel lens 24. It also carries therein the electric field plates 46 and 48 as well as the magnetic field pole pieces 50 and 52 Permanent magnet 102 provides the magnetic field. Port 104 provides access to apply the appropriate potential to center electrode 28 of einzel lens 24. Connector 106 and a similar connector on the other side provide separate connections to apply potential to the E plates. With the exception of those potentials, the entire module 100 operates at the voltage of top flange 80, 144 kV in the present example. The center element 28 of the einzel lens and the E plates are related to that flange voltage as excursions therefrom.

The upper element 40 of the pre-accel lens 38 operates at 144 kV maximum and this is the lower plate in module 100 in Fig. 2. Above lower plate 40 in module 100 and closely spaced therefrom is the aperture plate 36. The small opening 34 in that plate is the mass separator opening, and the flat upper plane of the aperture plate 36 is at the focal point of the beam as focused by objective lens 24. It is by positioning the aperture plate 36 at the focal plane that maximum separation is achieved. It is by positioning the ExB separator in the lower energy region between lenses 24 and 38 that maximum deflection of unwanted ions can be achieved with minimum field strength, and thus minimum perturbation of the path of the desired ions.

As is seen in Fig. 1, tension tube 88 is bolted to top flange 80 and it is also secured to base plate 68 to secure that structure into one assembly. The upper flange 72 carries drift tube 74 on spider 108, and the upper element 56 of final accelerator lens 54 is carried on the lower end of drift tube 74, see Fig. 1. The open areas between the arms of the spider and in both the upper and lower flanges permit vacuum pumping of the upper portion of the column and the source from the bottom of the column. Preferably, the entire column is pumped from the bottom through the target chamber. The region within drift tube 74 is a drift region where the beam expands from a waist of about 2 micrometers to a diameter of about 250 micrometers. This is the normal spreading of the beam beyond the focal point at the top surface of aperture plate 36. At the lower end of the drift region, aperture 110 in the electrode 56 insures that the beam passes through the center of the final lens. The majority of the energy gain occurs in tha final lens across the gap between electrodes 56 and 58. Beam deflector 64 below the final accelerator lens 54 provides the final scan deflection of the beam across the wafer target 60. This deflector must deflect the beam at its full potential and provide the speed and precision necessary for microfabrication.

Final beam energy is changed by changing the final lens accelerating potential between electrodes 56 and 58. Focus is maintained by controlling the potential on the preaccelerator lens electrodes 40 and 42 so that the beam energy out of electrode 42 is a constant fraction of total beam energy. The following table illustrate a six to one potential ratio on a preferred embodiment.

| Source extraction energy 12—20 | Pre-Accel 40—42 | Final Accel 56—58 | Total Beam energy 12—58 |
|---|---|---|---|
| 6 Kv | 0 Kv | 30 kV | 36 kV |
| 6 | 9 | 75 | 90 |
| 6 | 14 | 100 | 120 |
| 6 | 19 | 125 | .150 |

By thus changing the beam energy, depth of implantation can be controlled and sputter machining can be done.

This invention has been described in its presently contemplated best mode and it is clear that it is susceptible to numerous modifications, modes and embodiments within the ability of those skilled in the art and without the exercise of the inventive faculty. Accordingly, the scope of this invention is defined by the scope of the following claims.

## Claims

1. A method of forming a high resolution, focused ion beam having a small spot size and a high current density at a target for direct-write microfabrication, comprising the steps of:

forming (12, 20) an angularly expanding beam of a desired ion species at an initial energy level,

focusing (24) the beam to a crossover,

mass separating (44) the beam downstream of said focusing to deflect undesired ion species out of the beam path,

accelerating (38) the mass separated beam in the vicinity of the beam crossover to an intermediate energy level,

electrostatically focusing and accelerating (54) the beam beyond the crossover to a small spot with a high current density at a final energy level,

setting (66) the intermediate beam energy level and final beam energy level so that the intermediate energy beam level is a substantially constant fraction of the final beam energy level, and

deflecting (64) the spot over a target to implant a desired ion pattern on the target.

2. The method as claimed in claim 1, characterized in that the beam is electrostatically accelerated beyond the crossover to a single ion energy level of about 150 KeV in the course of varying the intermediate beam energy level.

3. An ion beam device for carrying out the method according to claim 1, the device comprising:

a column enclosure (70) around an ion beam path for maintaining a vacuum along the ion beam path;

an ion source (12) at one end of the ion beam path for providing ions of a selected species;

means (20) for extracting an angularly expanding ion beam from the source;

a target support (2) positioned at the other end of the ion beam path for positioning a target (60) on the ion beam path for receiving ions;

a first lens (24) positioned along the ion beam path between said ion source and said target support, said first lens being an objective lens focusing an image of said ion source at a first focal plane;

mass separating means comprising an ion analyzer (44) positioned downstream of said first lens for directing the selected ion species along the beam path and for directing undesired ion species away from the beam path, and an analyzer plate (36) lying substantially at said first focal plane and having an opening therethrough, said opening lying on the beam path so that undesired ion species strike said analyzer plate away from said opening;

energy control means (38) positioned in the beam path beyond the ion analyzer for accelerating the ion beam to an intermediate energy level;

an electrostatic accelerator lens (54) being a final accelerator lens for accelerating the ion beam as well as focusing and demagnifying the image of the ion beam at said first focal plane on to a target on said target support so that a demagnified image of said ion source is focused on the target;

a variable power supply (66) connected to apply respective voltage differentials across the energy control means and accelerator lens sufficient to focus the beam to a small spot with a high current density and to establish the intermediate energy level of the beam emerging from the energy control means at a substantially constant fraction of the beam energy emerging from the accelerator lens as the power supply is varied; and

means (64) for deflecting the focus beam relative to the target in a desired manner.

4. An ion beam device as claimed in claim 3 characterized in that the first lens (24) is a low aberration focusing lens positioned to focus the beam to a crossover without substantially increasing the beam energy.

5. An ion beam device as claimed in claim 3 characterized in that the ion analyzer (44) operates with relatively weak fields corresponding to a relatively low initial beam energy and thereby imparting little aberration to the beam.

6. An ion beam device as claimed in claim 3 characterized in that the power supply (66) is capable of applying respective voltage differentials across electrodes of the energy control means and electrostatic accelerator lens sufficient to accelerate the beam to a single ion energy level of about 150 KeV.

7. An ion beam device as claimed in claim 3 characterized in that the extraction means (20) comprises an extraction electrode connected to receive substantially the same voltage from the power supply (66) as an upstream electrode (40) of the energy control means (38), and a downstream electrode (42) of the energy control means (38) is connected to receive substantially the same voltage as an upstream electrode (56) of the electrostatic accelerator lens.

**Patentansprüche**

1. Verfahren zur Herstellung eines hochauflösenden fokussierten Ionenstrahls mit einem Brennfleck kleiner Größe und einer hohen Stromdichte am Zielobjekt für die Direkt-Schreib-Mikrochipfabrikation, das folgende Schritte umfaßt:

Bilden (12, 20) eines winkelig aufgespreizten Ionenstrahls einer gewünschten Art mit einem Anfangsenergiepegel,

Fokussieren (24) des Strahls auf einen Kreuzungspunkt,

Massenseparieren (44) des Strahls, bezüglich des Fokussierens stromabwärts, um nichtgewünschte Ionenarten aus dem Strahlenweg auszulenken,

Beschleunigen (38) des massenseparierten Strahls in der Nähe des Strahlkreuzungspunktes auf einen mittleren Energiepegel,

elektrostatisches Fokussieren und Beschleunigen (54) des Strahls jenseits des Kreuzungspunktes auf einen kleinen Brennfleck mit hoher Stromdichte bei einem hohen Energiepegel,

Einstellen (66) des mittleren und des endgültigen Strahlenergiepegels derart, daß der mittlere Strahlenergiepegel im wesentlichen ein konstanter Bruchteil des endgültigen Strahlenergiepegels ist, und

Ablenken (64) des Brennflecks auf dem Zielobjekt, um das gewünschte Ionenmuster in das Zielobjekt zu implantieren.

2. Verfahren nach Anspruch 1, dadurch gekennzeichnet, daß der Strahl während des Variierens de mittleren Strahlenergiepegels jenseits des Kreuzungspunktes elektrostatisch auf einen Einzelionenenergiepegel von ungefähr 150 KeV beschleunigt wird.

3. Ionenstrahlgerät zum Durchführen des Verfahrens nach Anspruch 1, gekennzeichnet durch:

ein Kolonnengehäuse (70) um einen Ionenstrahlweg zur Aufrechterhaltung eines Vakuums entlang des Ionenstrahlwegs,

eine Ionenquelle (12) an einem Ende des Ionenstrahlwegs zum Bereitstellen von Ionen einer gewünschten Art,

eine Einrichtung (20) zum Extrahieren eines winkelig aufgespreizten Ionenstrahls aus der Quelle,

eine am anderen Ende des Ionenstrahlwegs angeordnet Zielobjekthalterung (2) zur Positionierung eines Zielobjekts (60) im Ionenstrahlweg zum Aufnehmen von Ionen,

eine im Ionenstrahlweg zwischen der Ionenquelle und der Zielobjekthalterung angeordnete erste Linse (24), wobei es sich bei dieser ersten Linse um eine Objektivlinse handelt, die ein Bild der Ionenquelle auf eine erste Fokalebene fokussiert,

eine Massenseparatorvorrichtung mit einem Ionenanalysator (44), der stromabwärts der ersten Linse angeordnet ist, um die gewünschte Ionenart entlang dem Strahlweg zu lenken und um die nichtgewünschte Ionenart aus dem Strahlweg auszulenken, und einer Analysatorplatte (36), die im wesentlichen in der ersten Fokalbene liegt und eine Öffnung aufweist, die im Strahlweg liegt, so daß nichtgewünschte Ionenarten die Analysatorplatte außerhalb der Öffnung treffen,

eine jenseits des Ionenanalysators im Strahlenweg angeordneten Energieregeleinrichtung (38) zum Beschleunigen des Ionenstrahls auf einen mittleren Energiepegel,

eine elektrostatische Beschleunigungslinse (54), die eine letzte Beschleunigungslinse ist, um den Ionenstrahl sowohl zu beschleunigen als auch auf ein Zielobjekt auf der Zielobjekthalterung zu fokussieren und das Bild des Ionenstrahls in der ersten Fokalebene zu verkleinern, so daß ein verkleinertes Bild der Ionenquelle auf das Zielobjekt fokussiert wird,

eine variable Stromversorgung (66), die zur Zuführung von entsprechenden Differenzspannungen an die Energieregeleinrichtung und Beschleunigungslinsen dient, die groß genug sind, um den Strahl auf einen kleinen Brennfleck mit hoher Stromdichte zu fokussieren und den mittleren Energiepegel des aus der Energieregeleinrichtung austretenden Strahls auf einen im wesentlichen konstanten Bruchteil der aus der Beschleunigerlinse austretenden Strahlenergie einzurichten, während die Stromversorgung variiert wird, und

einer Einrichtung (64) zum Ablenken des fokussierten Strahls bezüglich des Zielobjekts in einer gewünschten Weise.

4. Ionenstrahlgerät nach Anspruch 3, dadurch gekennzeichnet, daß die erste Linse (24) eine Fokussierlinse geringer Abweichung ist, die derart angeordnet ist, daß der Strahl in einen Kreuzungspunkt fokus siert wird, ohne hierbei die Strahlenergie wesentlich zu erhöhen.

5. Ionenstrahlgerät nach Anspruch 3, dadurch gekennzeichnet, daß der Ionenanalysator (44) mit relativ schwachen Feldern entsprechend einer relativ niedrigen Strahlanfangsenergie arbeitet und somit den Strahl nur geringfügig abweichen läßt.

6. Ionenstrahlgerät nach Anspruch 3, dadurch gekennzichnet, daß die Stromversorgung (66) entsprechende Differenzspannungen an Elektroden der Energieregeleinrichtung und der elektrostatischen Beschleunigungslinse anlegt, welche ausreichend sind, den Strahl auf einen Einzelionenenenergiepegel von ungefähr 150 KeV zu beschleunigen.

7. Ionenstrahlgerät nach Anspruch 3, dadurch gekennzeichnet, daß die Extrahiereinrichtung (20) eine Extrahierelektrode aufweist, die derart geschaltet ist, daß sie die im wesentlichen gleiche Spannung von der Stromversorgung (66) wie eine stromaufwärts gelegene Elektrode (40) der Energieregeleinrichtung (38) erhält, und wobei eine stromabwärts gelegene Elektrode (42) der Energieregeleinrichtung (38) derart geschaltet ist, daß sie die im wesentlichen gleiche Spannung wie eine stromaufwärts gelegene Elektrode (56) der elektrostatischen Beschleunigungslinse erhält.

## Revendications

1. Procédé pour former un faisceau d'ions focalisé à haute résolution ayant, au niveau d'une cible, un point d'impact de faible taille et une densité de courant élevée pour une microfabrication à écriture directe, comprenant les étapes suivantes consistant à:

— former (12, 20) un faisceau divergent angulairement d'une espèce voulue d'ions, à un niveau initial d'énergie;
— focaliser (24) le faisceau vers un noeud,
— réaliser la séparation de masse (44) du faisceau en aval de cette focalisation pour dévier les espèces d'ions non voulues hors du trajet du faisceau,
— accélérer (38) le faisceau dont on a réalisé la séparation de masse au voisinage du noeud de faisceau jusqu'à un niveau intermédiaire d'énergie,
— focaliser et accélérer électrostatiquement (54) le faisceau au-delà du noeud vers un petit point d'impact avec une densité de courant élevée à un niveau final d'énergie,
— régler (66) le niveau intermédiaire d'énergie du faisceau et le niveau final d'énergie du faisceau de sorte que le niveau intermédiaire d'énergie du faisceau soit une fraction sensiblement constante du niveau final d'énergie du faisceau, et
— dévier (64) le point d'impact sur une cible pour implanter une configuration voulue d'ions sur la cible.

2. Procédé conforme à la revendication 1, caractérisé en ce que le faisceau est accéléré électrostatiquement au-delà du noeud jusqu'à un niveau unique d'énergie d'ions d'environ 150 KeV en faisant varier le niveau intermédiaire d'énergie.

3. Dispositif à faisceau d'ions pour mettre en oeuvre le procédé selon la revendication 1, ce dispositif comprenant:

— une enceinte en forme de colonne (70) entourant un trajet de faisceau d'ions pour maintenir un vide le long du trajet de faisceau d'ions,
— une source d'ions (12) à l'une des extrémités du trajet de faisceau d'ions pour fournir des ions d'une espéce choisie;
— des moyens (20) pour extraire un faisceau d'ions divergent angulairement à partir de la source;
— un support de cible (2) placé à l'autre extrémité du trajet de faisceau d'ions pour positionner une cible (60) sur le trajet de faisceau d'ions pour recevoir des ions;
— une première lentille (24) placée sur le trajet de faisceau d'ions entre la source d'ions et le support de cible, cette première lentille étant une lentille objectif focalisant une image de la source d'ions en un premier plan focal;

— des moyens pour réaliser une séparation de masse comprenant un analyseur d'ions (44) placé en aval de la première lentille pour diriger l'espèce d'ions choisie le long du trajet de faisceau et pour éloigner des espèces d'ions non désirées du trajet de faisceau, et une plaque d'analyseur (36) s'étendant sensiblement dans ce premier plan focal et présentant une ouverture, cette ouverture étant placée sur le trajet de faisceau de sorte que les espèces d'ions non désirées frappent cette plaque d'analyseur à l'extérieur de l'ouverture;

— des moyens de commande d'énergie (38) placés sur le trajet de faisceau au-dèla de l'analyseur d'ions pour accélérer le faisceau d'ions jusqu'à un niveau d'énergie intermédiaire;

— une lentille électrostatique accélératrice (54) servant de lentille accélératrice finale pour accélérer le faisceau d'ions ainsi que pour focaliser et réduire l'image du faisceau d'ions au niveau du premier plan focal vers une cible située sur le support de cible, de sorte qu'une image réduite de la source d'ions soit focalisée sur la cible;

— une alimentation à puissance variable (66) reliée de façon à appliquer aux bornes des moyens de commande d'énergie et de la lentille accélératrice des différentielles de tension respectives suffisantes pour focaliser le faisceau sur un petit point d'impact avec une densité de courant élevée et pour établir le niveau intermédiaire d'énergie du faisceau émergeant des moyens de commande d'énergie à une fraction sensiblement constante de l'énergie du faisceau émergeant de la lentille accélératrice lorsque la puissance d'alimentation varie, et

— des moyens (64) pour dévier le faisceau focalisé par rapport à la cible de façon voulue.

4. Dispositif à faisceau d'ions conforme à la revendication 3, caractérisé en ce que la première lentille (24) est une lentille convergente à faible aberration positionnée de façon à focaliser le faisceau sur un noeud sans augmenter sensiblement l'énergie du faisceau.

5. Dispositif à faisceau d'ions conforme à la revendication 3, caractérisé en ce que l'analyseur d'ions (44) fonctionne avec des champs relativement faibles correspondant à une énergie initiale de faisceau relativement basse, et générant de ce fait peu d'aberration pour le faisceau.

6. Dispositif à faisceau d'ions conforme à la revendication 3, caractérisé en ce que l'alimentation électrique (66) est capable d'appliquer des différentielles de tension respectives entre les électrodes des moyens de commande d'énergie et de la lentille électrostatique accélératrice suffisantes pour accélérer le faisceau jusqu'à un niveau unique d'énergie d'ions d'environ 150 KeV.

7. Dispositif à faisceau d'ions conforme à la revendication 3, caractérisé en ce que les moyens d'extraction (20) comprennent une électrode d'extraction connectée de façon à recevoir sensiblement la même tension de l'alimentation (66) qu'une électrode amont (40) faisant partie des moyens de commande d'énergie (38), et en ce qu'une électrode aval (42) faisant partie des moyens de commande d'énergie (38) est connectée de façon à recevoir sensiblement la même tension qu'une électrode amont (56) de la lentille électrostatique accélératrice.

Fig. 1.

Fig. 2.

0 079 931

Fig. 3.

3

Fig. 4.

POWER SUPPLY